# EUROPEAN PATENT APPLICATION

(11) **EP 4 765 534 A1**
(43) Date of publication of application: **24.06.2026**
(21) Application number: 25222171.8
(22) Date of filing: 10.12.2025
(51) Int. Cl.: H02H 3/087, H02H 9/00

(54) **SOLID-STATE CIRCUIT BREAKER AND METHOD FOR CONTROLLING RECLOSING OF SOLID-STATE CIRCUIT BREAKER**

(30) Priority: 11.12.2024 CN 202411822716
(71) Applicant: SCHNEIDER ELECTRIC INDUSTRIES SAS, 92500 Rueil-Malmaison (FR)
(72) Inventor: LIU, Xia, Shanghai 201203 (CN); SHI, Ying, Shanghai 201203 (CN); ZHANG, Fenglian, Shanghai 201203 (CN); LU, Feng, Shanghai 201203 (CN); BAI, Heng, Xi'An 710076 (CN); WANG, Hao, Shanghai 201203 (CN); ZHAO, Haijun, Shanghai 201203 (CN); CHEN, Jiamin, Shanghai 201203 (CN)
(74) Representative: Lavoix

(57) **Abstract**

The embodiment of the present disclosure relates to a solid-state circuit breaker and a method for controlling reclosing of the solid-state circuit breaker. The solid-state circuit breaker includes: a power electronic switch located in a main loop; an instantaneous trip protection circuit configured to output a first signal for controlling the power electronic switch based on a current in the main loop; a pulse width modulation (PWM) circuit configured to charge a load in a PWM current-limiting mode based on the current of the main loop and output a second signal for controlling the power electronic switch; and a gating circuit connected to the instantaneous trip protection circuit, the PWM circuit and the power electronic switch, and configured to selectively connect the instantaneous trip protection circuit or the PWM circuit with the main loop.

## Description

### TECHNICAL FIELD

The embodiment of the present disclosure relates to a solid-state circuit breaker and a method for controlling reclosing of the solid-state circuit breaker.

### BACKGROUND

Since a power electronic conversion apparatus is more and more involved in a power distribution system, a traditional mechanical circuit breaker is gradually replaced by a solid-state circuit breaker. At present, a power Metal-Oxide-Semiconductor Field-Effect Transistor (MOSFET) or an Insulate-Gate Bipolar Transistor (IGBT) is widely used as an instantaneous switch device in the solid-state circuit breaker. However, due to the limitation of device capability, when conditions such as surge or instantaneous short-circuit occur, the MOS or IGBT must be quickly turned off in a level of µs, resulting in power down of a load.

Therefore, there is required an automatic reclosing scheme, which can quickly restore a power supply for the load under a premise of guaranteeing that devices such as the MOS or IGBT do not fail, thus improving a continuity of the power supply for the load.

### SUMMARY

The embodiment of the present disclosure relates to a solid-state circuit breaker, comprising: a power electronic switch located in a main loop; an instantaneous trip protection circuit configured to output a first signal for controlling the power electronic switch based on a current in the main loop; a pulse width modulation (PWM) circuit configured to charge a load in a PWM current-limiting mode based on the current of the main loop, and output a second signal for controlling the power electronic switch; and a gating circuit connected to the instantaneous trip protection circuit, the PWM circuit and the power electronic switch, and configured to selectively connect the instantaneous trip protection circuit or the PWM circuit with the main loop.

In an example, the gating circuit is configured to connect the PWM circuit with the main loop after the instantaneous trip protection circuit outputs the first signal to turn off the power electronic switch at an initial turn-off time.

In an example, the power electronic switch is turned on after a delay period has elapsed since it was turned off, and the PWM circuit is configured to charge the load with a PWM pulse based on the current of the main loop in a charging period after the delay period.

In an example, when a charging voltage of a fast-charging and slow-discharging capacitor causes a short-circuit self-locking threshold to be reached during the charging period, the PWM circuit is configured to output the second signal for turning off the power electronic switch, and wherein the gating circuit is further configured to disconnect the PWM circuit from the main loop and connect the reset instantaneous trip protection circuit with the main loop after an ending of the charging period.

In an example, when a charging voltage of a fast-charging and slow-discharging capacitor causes a short-circuit self-locking threshold not to be reached during the charging period, the gating circuit is further configured to disconnect the PWM circuit from the main loop and connect the reset instantaneous trip protection circuit with the main loop after an ending of the charging period.

In an example, when the instantaneous trip protection circuit outputs the first signal for turning off the power electronic switch again after the ending of the charging period, a circuit fault is identified.

In an example, when the instantaneous trip protection circuit does not output the first signal after the ending of the charging period, the solid-state circuit breaker operates normally.

In an example, the PWM circuit is configured to output the second signal for turning off the power electronic switch before the ending of the charging period to turn off the solid-state circuit breaker and make it lockout.

In an example, the PWM circuit comprises: a PWM current-limiting circuit configured to limit the current of the main loop and generate the PWM pulse; a self-locking determination circuit configured to determine whether a self-locking threshold is reached based on a charging voltage of a fast-charging and slow-discharging capacitor, and output a self-locking determination signal; and an OR gate configured to be connected to the PWM current-limiting circuit and the self-locking determination circuit, and output the second signal.

In an example, the solid-state circuit breaker further comprises: a microcontroller unit (MCU) connected to the instantaneous trip protection circuit, the PWM current-limiting circuit, the self-locking determination circuit and the gating circuit, and configured to: output a switching signal to the gating circuit to connect the instantaneous trip protection circuit or the PWM circuit with the main loop; enable the power electronic switch to be turned on; output a reset signal to the instantaneous trip protection circuit; and output a reset signal to the self-locking determination circuit.

The embodiment of the present disclosure relates to a method for controlling reclosing of a solid-state circuit breaker, the method including: turning off a power electronic switch in the solid-state circuit breaker through an instantaneous trip protection circuit at an initial turn-off time; connecting a pulse width modulation (PWM) circuit with a main loop; turning on the power electronic switch after a delay period has elapsed; charging a load through the PWM circuit in a PWM current-limiting mode during a charging period; and disconnecting the pulse width modulation (PWM) circuit from the main loop and connecting the reset instantaneous trip protection circuit with the main loop after an ending of the charging period.

In an example, the method further includes: turning off the solid-state circuit breaker and making it lockout based on a self-locking determination signal output from the PWM circuit during the charging period.

In an example, the method further includes: the solid-state circuit breaker operates normally after the reset instantaneous trip protection circuit is connected with the main loop.

In an example, the method further includes: turning off the power electronic switch again through the instantaneous trip protection circuit after the reset instantaneous trip protection circuit is connected with the main loop.

The embodiment of the present disclosure further relates to a solid-state circuit breaker, comprising: a power electronic switch located in a main loop; an instantaneous trip protection circuit configured to output a first signal for controlling the power electronic switch based on a current in the main loop; a PWM current-limiting circuit configured to limit the current of the main loop and generate a PWM pulse; a self-locking determination circuit configured to compare a charging voltage of a fast-charging and slow-discharging capacitor with a self-locking threshold and output a self-locking determination signal; an OR gate configured to be connected to the PWM current-limiting circuit and the self-locking determination circuit; and a gating circuit connected to the instantaneous trip protection circuit, the OR gate and the power electronic switch, and configured to selectively connect the instantaneous trip protection circuit or the PWM current-limiting circuit and the self-locking determination circuit with the main loop.

In an example, the solid-state circuit breaker further comprises: a microcontroller unit (MCU) connected to the instantaneous trip protection circuit, the PWM current-limiting circuit and the gating circuit, and configured to: output a switching signal to the gating circuit to connect the instantaneous trip protection circuit or the PWM current-limiting circuit, the self-locking determination circuit and the OR gate with the main loop; enable the power electronic switch to be turned on; output a reset signal to the instantaneous trip protection circuit; and output a reset signal to the self-locking determination circuit.

According to the embodiment of the present disclosure, after the power electronic switch in the solid-state circuit breaker is turned off by the instantaneous trip protection circuit, different responses can be made according to various states such as a surge condition, a short-circuit condition and a high-impedance long-line short-circuit condition, so as to reclose the solid-state circuit breaker or report a fault.

Under the short-circuit condition and the high-impedance long-line short-circuit condition, the solid-state circuit breaker is turned off, and the continuity of power supply can be guaranteed in the case of surge and transient current oscillation.

### BRIEF DESCRIPTION OF THE DRAWINGS

The above and other aspects, features and advantages of specific embodiments of the present disclosure will become more apparent from the following description taken in conjunction with the accompanying drawings, in which:
FIG. 1 is a schematic block diagram illustrating a solid-state circuit breaker according to an embodiment of the present disclosure;
FIG. 2 illustrates a schematic connection diagram of a reclosing control circuit and a main loop according to an embodiment of the present disclosure;
FIG. 3 illustrates an exemplary timing diagram of a solid-state circuit breaker operating under a negative surge condition according to an embodiment of the present disclosure;
FIG. 4 illustrates an exemplary timing diagram of a solid-state circuit breaker operating under a positive surge condition according to an embodiment of the present disclosure;
FIG. 5 illustrates an exemplary timing diagram of a solid-state circuit breaker operating under a short-circuit condition according to an embodiment of the present disclosure;
FIG. 6 illustrates an exemplary timing diagram of a solid-state circuit breaker operating under a high-impedance long-line short-circuit condition according to an embodiment of the present disclosure;
FIG. 7 illustrates a schematic flowchart of a method for controlling reclosing of a solid-state circuit breaker according to an embodiment of the present disclosure;
FIG. 8 illustrates a schematic flowchart of a method for controlling reclosing of a solid-state circuit breaker according to another embodiment of the present disclosure;
FIG. 9 illustrates a schematic block diagram of a solid-state circuit breaker according to another embodiment of the present disclosure;
FIG. 10 illustrates a schematic circuit topology diagram of a solid-state circuit breaker according to another embodiment of the present disclosure; and
FIG. 11 illustrates a simplified circuit topology diagram of a solid-state circuit breaker according to another embodiment of the present disclosure.

### DETAILED DESCRIPTION

Before undertaking the DETAILED DESCRIPTION below, it may be advantageous to set forth definitions of certain words and phrases used throughout the present disclosure. The terms "include" and "comprise," as well as derivatives thereof, refer to inclusion without limitation. The term "controller" or "control unit" refers to any device, system or part thereof that controls at least one operation. Such controller may be implemented in hardware or a combination of hardware and software and/or firmware. For example, the controller may include, for example, an application specific integrated circuit (ASIC), a general or specific central processing unit (CPU), a digital signal processor (DSP), and a programmable logic device such as a field programmable gate array (FPGA). The controller may be manufactured as a single printed circuit board (PCB) or distributed on several interconnected PCBs. The controller may include other processing circuits. For example, the controller may include two processing circuits such as an FPGA and a CPU connected to each other on a PCB. The functionality associated with any particular controller may be centralized or distributed, whether locally or remotely. The phrase "at least one", when used with a list of items, means that different combinations of one or more of the listed items may be used, and only one item in the list may be needed. For example, "at least one of A, B and C" includes any of the following combinations: A, B, C, A and B, A and C, B and C, A and B and C. Meanwhile, in the description of the present disclosure, the terms "first" and "second" are only used for distinguishing descriptions, and cannot be understood as indicating or implying relative importance or ranking. In the embodiment of the present disclosure, unless otherwise specified, "connect" does not mean that it must be "direct connect" or "direct contact", but only requires electrical connection.

Definitions of other specific words and phrases are provided throughout the present disclosure. Those skilled in the art should understand that in many cases, if not most cases, such definitions also apply to the previous and future uses of words and phrases so defined.

The following various embodiments in the present disclosure that describe the principles of the present disclosure in connection with the accompanying drawings are only for illustration and should not be construed as limiting the scope of the present disclosure in any way. Those skilled in the art will understand that the principles of the present disclosure can be implemented in any suitably arranged system or device. In some cases, the actions described in the present disclosure can be performed in different orders and the desired results can be still achieved. In addition, the processes depicted in the drawings do not necessarily require the illustrated specific order or sequential order to achieve the desired results. In the specific implementations, multitask and parallel processing may be advantageous.

The text and drawings are provided as examples only to help understand the present disclosure. They should not be construed as limiting the scope of the appended claims in any way. Although certain embodiments and examples have been provided, based on the contents of the present disclosure, it is apparent to those skilled in the art that changes can be made to the illustrated embodiments and examples without departing from the scope of the present disclosure.

In the scheme of the prior art, hardware overcurrent protection only responds to the current. Due to the limitation of device capability, it is necessary to set a short-circuit protection point at a certain value to guarantee that it will not be damaged under special conditions such as short-circuit and surge. Therefore, this results in the hardware overcurrent protection being unable to distinguish among short-circuit, surge and transient current oscillation. Under a short-circuit condition, a solid-state circuit breaker must be turned off. However, the surge and transient current oscillation are to guarantee the continuity of power supply.

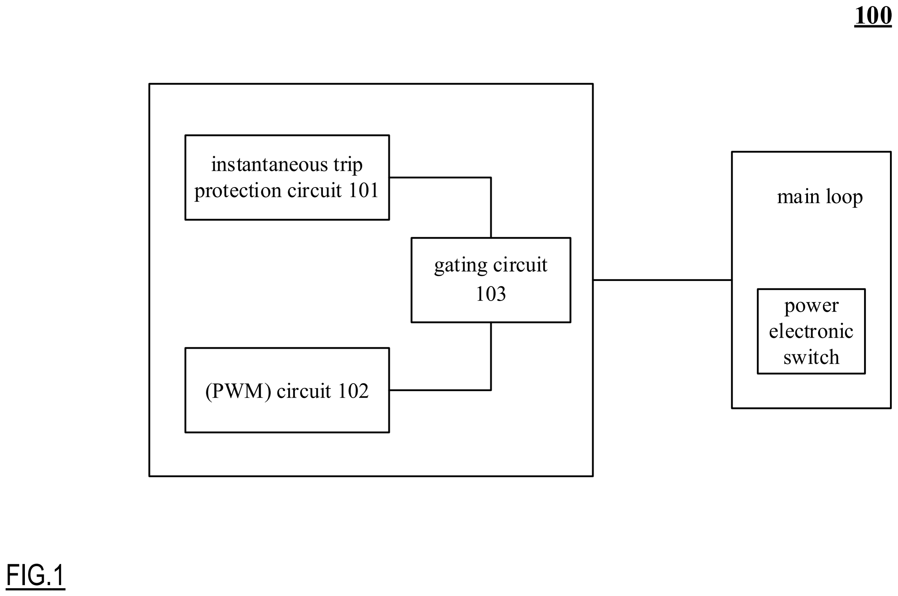

FIG. 1 is a schematic block diagram illustrating a solid-state circuit breaker 100 according to an embodiment of the present disclosure.

As shown in FIG. 1, the solid-state circuit breaker 100 includes: a power electronic switch located in a main loop; an instantaneous trip protection circuit 101 configured to output a first signal for controlling the power electronic switch based on a current in a main loop; a pulse width modulation (PWM) circuit 102 configured to charge a load in a PWM current-limiting mode based on the current of the main loop, and output a second signal for controlling the power electronic switch; and a gating circuit 103 connected to the instantaneous trip protection circuit 101 and the PWM circuit 102 and the power electronic switch, and configured to selectively connect the instantaneous trip protection circuit or the PWM circuit with the main loop.

According to the embodiment of the present disclosure, the gating circuit may selectively connect the instantaneous trip protection circuit 101 or the PWM circuit 102 with the main loop and the power electronic switch included in the main loop, so that after the power electronic switch is turned off by the instantaneous trip protection circuit 101, the solid-state circuit breaker may be reclosed or a fault may be reported according to various states such as a surge condition, a short-circuit condition and a high-impedance long-line short-circuit condition.

The solid-state circuit breaker 100 according to an embodiment of the present disclosure may be both a unidirectional solid-state circuit breaker and a bidirectional solid-state circuit breaker.

In an example, the gating circuit 103 may be configured to connect the PWM circuit 102 with the main loop after the instantaneous trip protection circuit outputs the first signal to turn off the power electronic switch at an initial turn-off time.

In an example, the power electronic switch may be turned on after a delay period has elapsed since it was turned off, and the PWM circuit 102 may be configured to charge the load with a PWM pulse based on the current of the main loop in a charging period after the delay period.

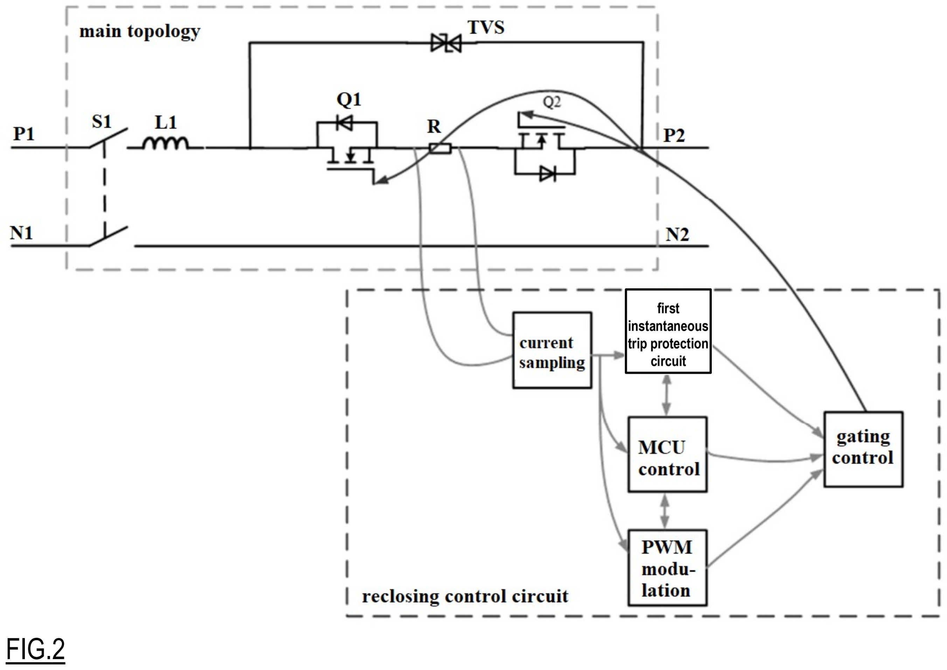

FIG. 2 illustrates a schematic connection diagram of a reclosing control circuit and a main loop according to an embodiment of the present disclosure. The solid-state circuit breaker 100 shown in FIG. 1 may include the reclosing control circuit and the main loop as shown in FIG. 2.

Those skilled in the art should understand that the reclosing control circuit shown in FIG. 2 is only one of the implementations according to the embodiment of the present disclosure, but the embodiment of the present disclosure is not limited thereto, and the solid-state circuit breaker according to the embodiment of the present disclosure can also be implemented as other various forms.

As shown in FIG. 2, a topology of the main loop may be composed of input terminals P1-N1, a mechanical switch S1, a power inductor L1, power electronic switches Q1-Q2, a sampling resistor R, a power transient voltage suppressor TVS and output terminals P2-N2. Driving commands of the power electronic switches in the topology of the main loop come from the reclosing control circuit, which can effectively switch on and off the main loop according to an output of the reclosing control circuit.

The reclosing control circuit may include a first instantaneous trip protection circuit, a PWM modulation circuit, a gating control circuit and an MCU control circuit which may provide certain logic support, wherein the MCU control circuit may be omitted. The first instantaneous trip protection circuit in FIG. 2 may correspond to the instantaneous trip protection circuit 101 in FIG. 1, the PWM modulation circuit in FIG. 2 may correspond to the PWM circuit 102 in FIG. 1, and the gating control circuit in FIG. 2 may correspond to the gating circuit 103 in FIG. 1.

In FIG. 2, input signals of the gating control circuit are output signals of the first instantaneous trip protection circuit, the PWM modulation circuit and the MCU control circuit, and these input signals control an output of the gating control circuit according to reclosing protection logic, and then may control the power electronic switches in the topology of the main loop to be effectively switched on and off.

Hereinafter, the embodiments of the present disclosure will be described in more detail with various conditions as examples.

### First Example-Surge Condition

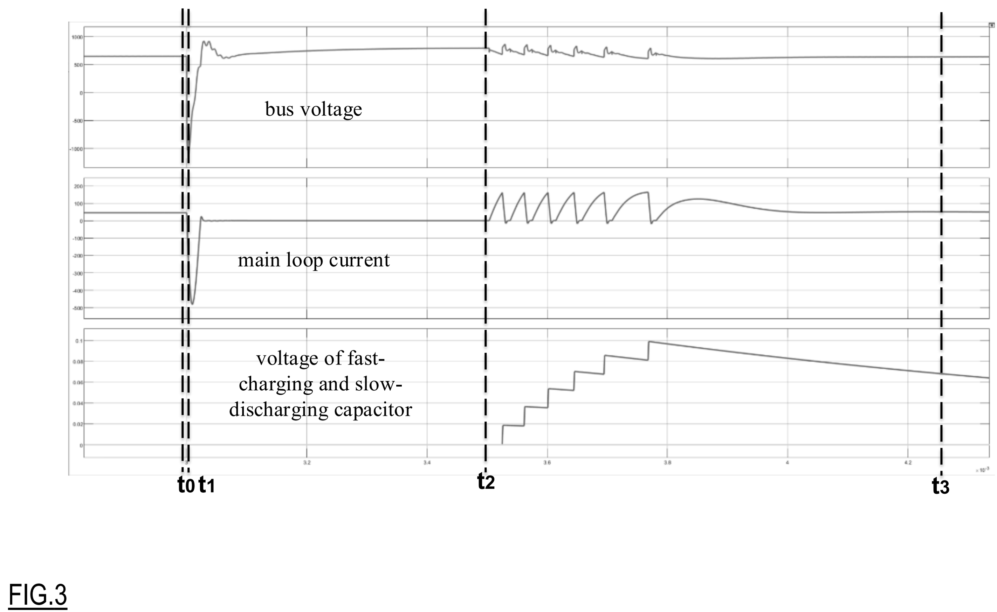

FIG. 3 illustrates an exemplary timing diagram of a solid-state circuit breaker operating under a negative surge condition according to an embodiment of the present disclosure.

As shown in FIG. 3, at a time t0, a surge current occurs in a main loop. The time t0 may be referred to as an instantaneous short-circuit occurrence time.

At a time t1, the power electronic switches Q1-Q2 are turned off by a first signal output by the instantaneous trip protection circuit 101. The time t1 may be referred to as an initial turn-off time.

During the time t1 to the time t2, in the main loop, the mechanical switch maintains being closed and the power electronic switch maintains being turned off. This stage may be referred to as a delay period, which is used by the solid-state circuit breaker to avoid a large current output, and may also be considered as "avoidance" for conditions such as surge or instantaneous short-circuit. During the delay period, a voltage of a load will continue to be decreased. Therefore, a length between the time t1 to the time t2 needs to be set according to system parameters, to guarantee that the voltage of the load is not too low to cause the load to be powered off, and that PWM debugging could be restarted successfully in a later period, and that a large current could be avoided to prevent the solid-state circuit breaker from overstressing.

A waiting time between a first instantaneous trip of the instantaneous trip protection circuit 101 and reclosing of the solid-state circuit breaker may be estimated by considering the surge, a length range of a system cable and a working voltage, so as to minimize a power-off time of the solid-state circuit breaker.

The delay period t1~t2 may avoid line oscillation caused by trailing effect of the surge.

The power electronic switch may be turned on after the delay period has elapsed since it was turned off at the time t1, that is, at the time t2, the power electronic switch may be turned on. From the time t2, in the main loop, the mechanical switch maintains being closed and the power electronic switch maintains being turned on. A current in the main loop may be controlled by a PWM circuit 102 instead of the instantaneous trip protection circuit 101.

During the delay period or just at an ending of the delay period, a gating circuit 103 may disconnect the instantaneous trip protection circuit 101 from the main loop and connect the PWM circuit 102 with the main loop.

In an example, the gating circuit 103 may perform an operation of disconnecting the instantaneous trip protection circuit 101 from the main loop and connecting the PWM circuit 102 with the main loop according to a switching signal from a microcontroller unit (MCU).

In an example, a signal representing the current in the main loop may be transmitted to the PWM circuit 102 and/or the instantaneous trip protection circuit 101 and/or the MCU through a current detection sensor and a current detection circuit. The current detection sensor is, for example, the sampling resistor R shown in FIG. 2.

At the time t2, a load(s) in the PWM circuit 102 may be charged by a PWM pulse based on the current of the main loop during a period t2~t3 after the delay period t1~t2. Therefore, the period t2~t3 may also be referred to as a charging period. A time length of the period t2~t3 may be determined in advance according to system parameters or set by the MCU.

The PWM circuit 102 may limit the current of the main loop, generate the PWM pulse, and charge the load in the PWM circuit 102 with the PWM pulse. In an example, the load may be one or more fast-charging and slow-discharging capacitors arranged in the PWM circuit 102.

Here, PWM parameters may be set in connection with system configurations.

As shown in FIG. 3, under the negative surge condition, during the charging period t2~t3, a voltage of a capacitive load, located at a down-stage of the solid-state circuit breaker and included in the PWM circuit 102, achieves "net increasing" during the charging period t2~t3 through a fast-charging and slow-discharging process, and after several control cycles, a voltage difference between an output voltage and an input voltage is reduced and basically equalized, that is, the voltage of the capacitive load located at the down-stage of the solid-state circuit breaker is basically consistent with a bus voltage.

Therefore, at the ending of the charging period, the voltage of the fast-charging and slow-discharging capacitor in the self-locking determination circuit included in the PWM circuit 102 does not cause a short-circuit self-locking threshold to be reached, and the PWM circuit 102 does not output a signal for turning off the power electronic switch.

At a time t3, the gating circuit 103 may be configured to disconnect the PWM circuit 102 from the main loop and connect the reset instantaneous trip protection circuit 101 with the main loop again.

At this time, the instantaneous trip protection circuit 101 will not trigger an instantaneous trip of the power electronic switch again, and the solid-state circuit breaker is successfully reclosed, thereby operating normally.

In fact, under the negative surge condition, the solid-state circuit breaker has completed the reclosing before the time t3.

According to the embodiment of the present disclosure, under the negative surge condition, the solid-state circuit breaker according to the embodiment of the present disclosure can automatically and quickly restore power supply, thus avoiding long-term powering down of the load and improving the continuity of power supply for the load.

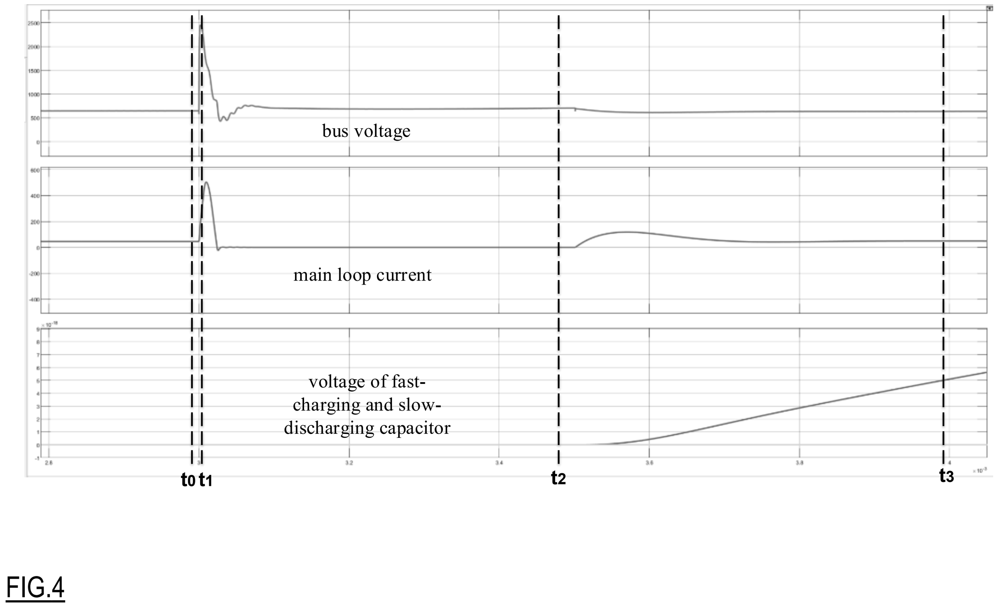

FIG. 4 illustrates an exemplary timing diagram of a solid-state circuit breaker operating in a positive surge condition according to an embodiment of the present disclosure.

The positive surge condition shown in FIG. 4 is similar to the negative surge condition shown in FIG. 3, and the repetition is not repeated here.

As shown in FIG. 4, at a time t3, the voltage of the fast-charging and slow-discharging capacitor in the self-locking determination circuit included in the PWM circuit 102 does not reach the short-circuit self-locking threshold, so the PWM circuit 102 does not output a signal for turning off a power electronic switch. Therefore, after the gating circuit 103 disconnects the PWM circuit 102 from the main loop and connects the reset instantaneous trip protection circuit 101 with the main loop, the instantaneous trip protection circuit 101 will not trigger an instantaneous trip of the power electronic switch again, and the solid-state circuit breaker is successfully reclosed, thereby operating normally.

Similar to FIG. 3, in fact, the solid-state circuit breaker has completed the reclosing before the time t3.

The periods t0~t1, t1~t2 and t2~t3 as shown in FIG. 4 may be the same as or different from the periods t0~t1, t1~t2 and t2~t3 as shown in FIG. 3.

Therefore, under the positive surge condition, the solid-state circuit breaker according to the embodiment of the present disclosure can also automatically and quickly restore power supply, thus avoiding long-term powering down of the load and improving the continuity of power supply for the load.

### Second Example-Short-circuit Condition

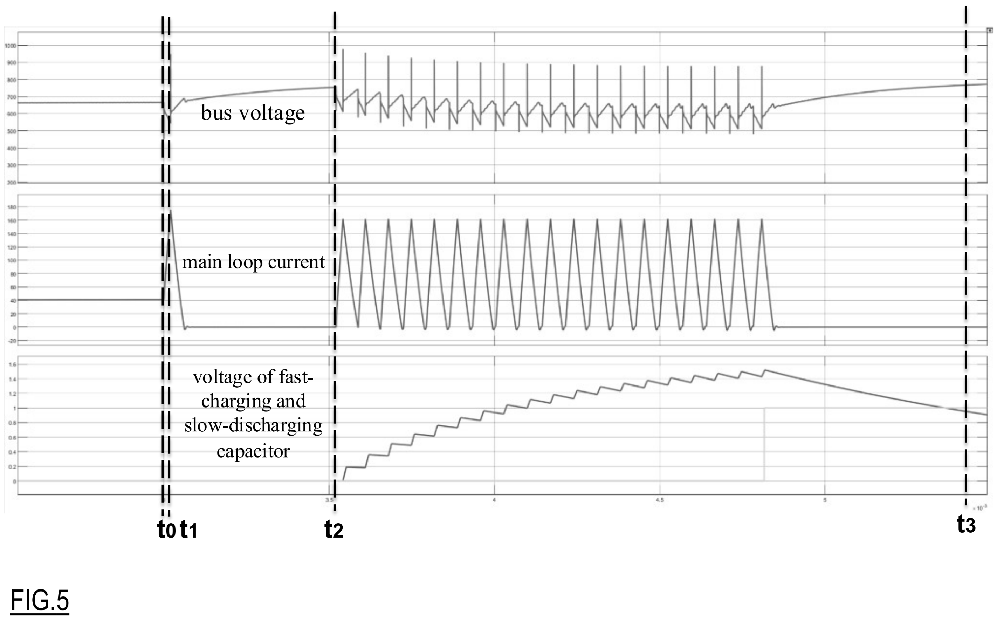

FIG. 5 illustrates an exemplary timing diagram of a solid-state circuit breaker operating in a short-circuit condition according to an embodiment of the present disclosure.

As shown in FIG. 5, at a time t0, a short-circuit current occurs in the main loop. Similarly, the time t0 may be referred to as an instantaneous short-circuit occurrence time.

At a time t1, the power electronic switches Q1Q2 are turned off by the first signal output by the instantaneous trip protection circuit 101. The time t1 may be referred to as an initial turn-off time.

During the time t1 to a time t2, in the main loop, a mechanical switch maintains being closed and the power electronic switch maintains being turned off. This stage may be referred to as the delay period, which is used by the solid-state circuit breaker to avoid a large current output, and may also be considered as "avoidance" for conditions such as surge or instantaneous short-circuit.

During the delay period or just at an ending of the delay period, the gating circuit 103 may disconnect the instantaneous trip protection circuit 101 from the main loop and connect the PWM circuit 102 with the main loop.

In an example, the gating circuit 103 may perform an operation of disconnecting the instantaneous trip protection circuit 101 from the main loop and connecting the PWM circuit 102 with the main loop according to a switching signal from a microprocessor unit (MCU).

The power electronic switch may be turned on after the delay period has elapsed since it was turned off at the time t1, that is, at the time t2, the power electronic switch may be turned on. From the time t2, in the main loop, the mechanical switch maintains being closed and the power electronic switch maintains being turned on. A current in the main loop may be controlled by the PWM circuit 102 instead of the instantaneous trip protection circuit 101.

In an example, a signal representing the current in the main loop may be transmitted to the PWM circuit 102 and/or the instantaneous trip protection circuit 101 and/or the MCU through a current detection sensor and a current detection circuit. The current detection sensor is, for example, the sampling resistor R shown in FIG. 2.

At the time t2, the load in the PWM circuit 102 may be charged by the PWM pulse based on the current of the main loop during the period t2~t3 after the delay period t1~t2. The period t2~t3 may be referred to as a charging period. A time length of the period t2~t3 may be determined in advance according to system parameters or set by the MCU.

The PWM circuit 102 may limit the current of the main loop, generate the PWM pulse, and charge a capacitive load in the PWM circuit 102 with the PWM pulse.

Different from the surge conditions as shown in FIGs. 3 and 4, as shown in FIG. 5, in the short-circuit condition, during the charging period t2~t3, the voltage of the fast-charging and slow-discharging capacitor in the self-locking determination circuit included in the PWM circuit 102 increases in a fast-charging and slow-discharging process of the self-locking determination circuit through switching characteristics of PWM, but a short-circuit self-locking threshold is reached. Therefore, during the charging period, the voltage of the fast-charging and slow-discharging capacitor in the self-locking determination circuit causes the short-circuit self-locking threshold to be reached, and the PWM circuit 102 outputs a signal for turning off the power electronic switch. The solid-state circuit breaker is turned off and locked again.

Since a short-circuit may still exist in the circuit, an energy due to the short-circuit is different due to a different impedance of the short-circuit or different impedance and inductive reactance in a line. However, switching frequency is relatively fast during short-circuit, and a temperature rise Tj of a MOSFET is very fast due to a large switching loss. Turning off the power electronic switch at a time t3 may damage the device, so PWM caused by short-circuit should be cut off as soon as possible. Therefore, a short-circuit self-locking circuit may be included in the PWM circuit to cut off a short-circuit fault adaptively in advance according to a line length and short-circuit energy.

At the time t3, the gating circuit 103 may be configured to disconnect the PWM circuit 102 from the main loop and connect the reset instantaneous trip protection circuit 101 with the main loop again. At this time, the solid-state circuit breaker has been turned off in advance, and the solid-state circuit breaker according to the embodiment of the present disclosure may perform state resetting and report a fault.

Similarly, the periods t0~t1, t1~t2 and t2~t3 as shown in FIG. 5 may be the same as or different from the periods t0~t1, t1~t2 and t2~t3 as shown in FIGs. 3 and 4.

According to the embodiment of the present disclosure, under the short-circuit condition, the solid-state circuit breaker according to the embodiment of the present disclosure can be turned off in advance, perform state resetting and report a fault.

### Third Example-High-Impedance Long-Line Short-circuit Condition

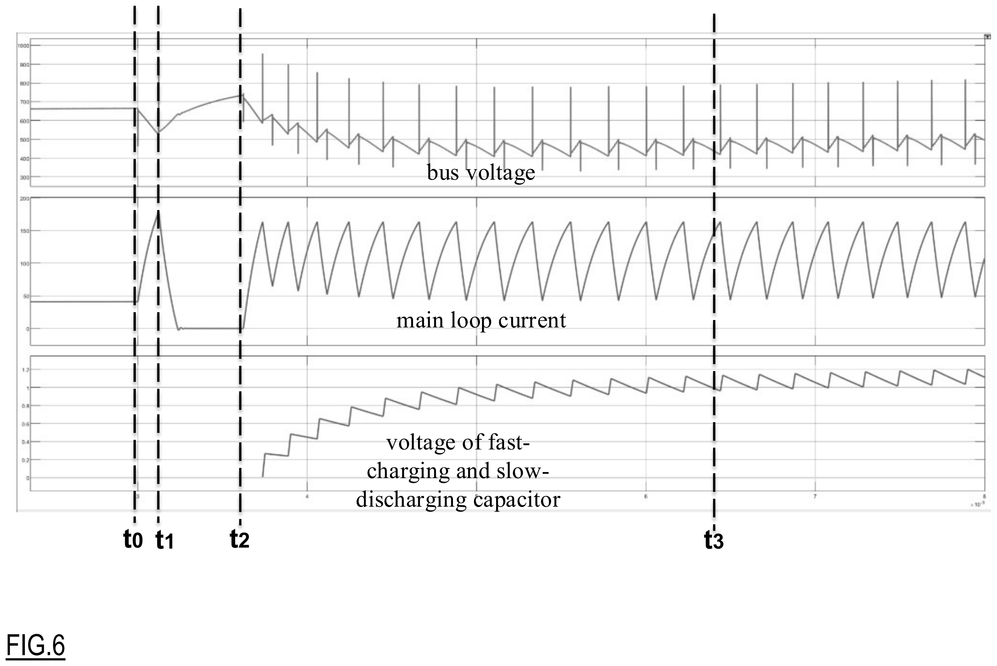

FIG. 6 illustrates an exemplary timing diagram of a solid-state circuit breaker operating in a high-impedance long-line short-circuit condition according to an embodiment of the present disclosure.

As shown in FIG. 6, at a time t0, a high-impedance long-line short-circuit occurs in the main loop. Similarly, the time t0 may be referred to as an instantaneous short-circuit occurrence time.

At a time t1, the power electronic switches Q1Q2 are turned off by the first signal output by the instantaneous trip protection circuit 101. The time t1 may be referred to as an initial turn-off time.

During the time t1 to a time t2, in the main loop, the mechanical switch maintains being closed and the power electronic switch maintains being turned off. This stage may be referred to as a delay period, which is used by the solid-state circuit breaker to avoid a large current output, and may also be considered as "avoidance" for conditions such as surge or instantaneous short-circuit.

During the delay period or just at an ending of the delay period, the gating circuit 103 may disconnect the instantaneous trip protection circuit 101 from the main loop and connect a PWM circuit 102 with the main loop.

In an example, the gating circuit 103 may perform an operation of disconnecting the instantaneous trip protection circuit 101 from the main loop and connecting the PWM circuit 102 with the main loop according to a switching signal from a microprocessor unit (MCU).

The power electronic switch may be turned on after the delay period has elapsed since it was turned off at the time t1, that is, at the time t2, the power electronic switch may be turned on. From the time t2, in the main loop, the mechanical switch maintains being closed and the power electronic switch maintains being turned on. A current in the main loop is controlled by the PWM circuit 102 instead of the instantaneous trip protection circuit 101.

In an example, a signal representing the current in the main loop may be transmitted to the PWM circuit 102 and/or the instantaneous trip protection circuit 101 and/or the MCU through a current detection sensor and a current detection circuit. The current detection sensor is, for example, the sampling resistor R shown in FIG. 2.

At the time t2, the load in the PWM circuit 102 may be charged by the PWM pulse based on the current of the main loop during a period t2~t3 after a delay period t1~t2. The period t2~t3 may be referred to as a charging period. A time length of the period t2~t3 may be determined in advance according to system parameters or set by the MCU.

The PWM circuit 102 may limit the current of the main loop, generate the PWM pulse, and charge the fast-charging and slow-discharging capacitor in the self-locking determination circuit in the PWM circuit 102 with the PWM pulse.

As shown in FIG. 6, under the high-impedance long-line short-circuit condition, during the charging period t2~t3, the fast-charging and slow-discharging capacitor in the self-locking determination circuit is always charged by the PWM pulse through the fast-charging and slow-discharging process, but it takes a long time to reach a charge-discharge balance or cause a short-circuit self-locking threshold to be reached. Therefore, until an end of the charging period t2~t3, PWM is always performed, and the PWM circuit 102 does not output a signal for turning off the power electronic switch.

However, such abnormal state is not allowed to be continued. Therefore, at a time t3, the gating circuit 103 may be configured to disconnect the PWM circuit 102 from the main loop and connect the reset instantaneous trip protection circuit 101 with the main loop again. At this time, the high-impedance long-line short-circuit condition in the main loop causes the solid-state circuit breaker to be turned off again through the reset instantaneous trip protection circuit 101.

Since a first instantaneous trip has been triggered previously, the solid-state circuit breaker no longer enters a PWM mode and is turned off for protection, and the solid-state circuit breaker according to the embodiment of the present disclosure performs state resetting and reports a fault.

Similarly, the periods t0~t1, t1~t2 and t2~t3 as shown in FIG. 6 may be the same as or different from the periods t0~t1, t1~t2 and t2~t3 as shown in FIGs. 3 to 5.

According to the embodiment of the present disclosure, under the high-impedance long-line short-circuit condition, the solid-state circuit breaker according to the embodiment of the present disclosure may be turned off at the time t3 for protection, and perform state resetting and report a fault.

According to the embodiment of the present disclosure, the state resetting performed at the time t3 may have multiple implementations.

Therefore, according to the detailed descriptions with reference to FIGs. 3 to 6, the solid-state circuit breaker according to the embodiment of the present disclosure can make different responses to a surge condition, a short-circuit condition and the high-impedance long-line short-circuit condition. Under the short-circuit condition and the high-impedance long-line short-circuit condition, the solid-state circuit breaker is turned off, and in the case of the surge and transient current oscillation, the continuity of power supply can be guaranteed.

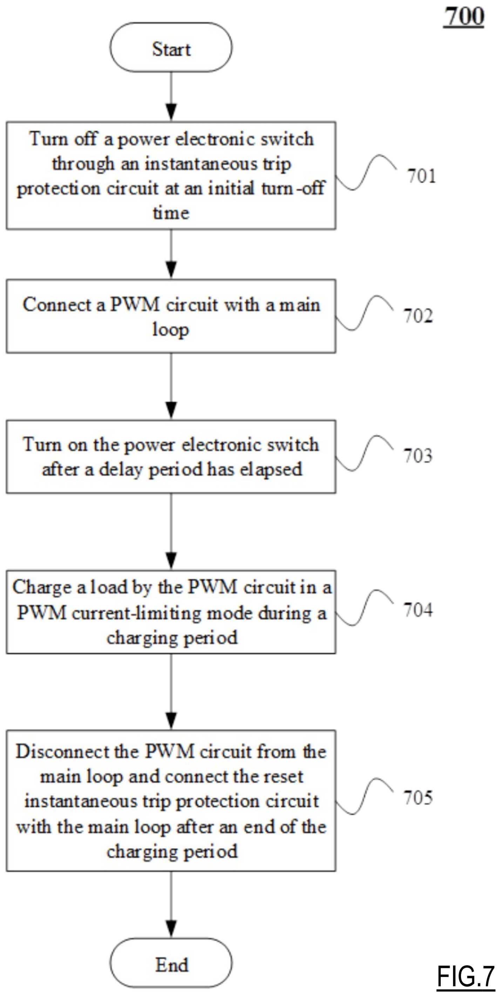

FIG. 7 illustrates a schematic flowchart of a method 700 for controlling reclosing of a solid-state circuit breaker according to an embodiment of the present disclosure.

As shown in FIG. 7, at 701 of the method 700, the power electronic switch is turned off through the instantaneous trip protection circuit at the initial turn-off time.

At 702, the pulse width modulation (PWM) circuit is connected with the main loop.

At 703, the power electronic switch is turned on after the delay period has elapsed.

At 704, the load is charged by the PWM circuit in the PWM current-limiting mode during the charging period.

At 705, the PWM circuit is disconnected from the main loop and the reset instantaneous trip protection circuit is connected with the main loop after an end of the charging period.

Therefore, the method for controlling the reclosing of the solid-state circuit breaker according to the embodiment of the present disclosure can make different responses to a surge condition, a short-circuit condition and a high-impedance long-line short-circuit condition. Under the short-circuit condition and the high-impedance long-line short-circuit condition, the solid-state circuit breaker is turned off, and in the case of surge and transient current oscillation, the continuity of power supply can be guaranteed.

In an example, during the charging period, the solid-state circuit breaker is turned off and locked based on a self-locking determination signal output from the PWM circuit.

In an example, after the reset instantaneous trip protection circuit is connected with the main loop, the solid-state circuit breaker operates normally.

In an example, after the reset instantaneous trip protection circuit is connected with the main loop, the solid-state circuit breaker is turned off again through the instantaneous trip protection circuit.

The delay period and the charging period may be counted by an MCU, but the counting may also be realized by various components through hardware.

In addition, switching by a gating circuit 103 may be realized under control of the MCU.

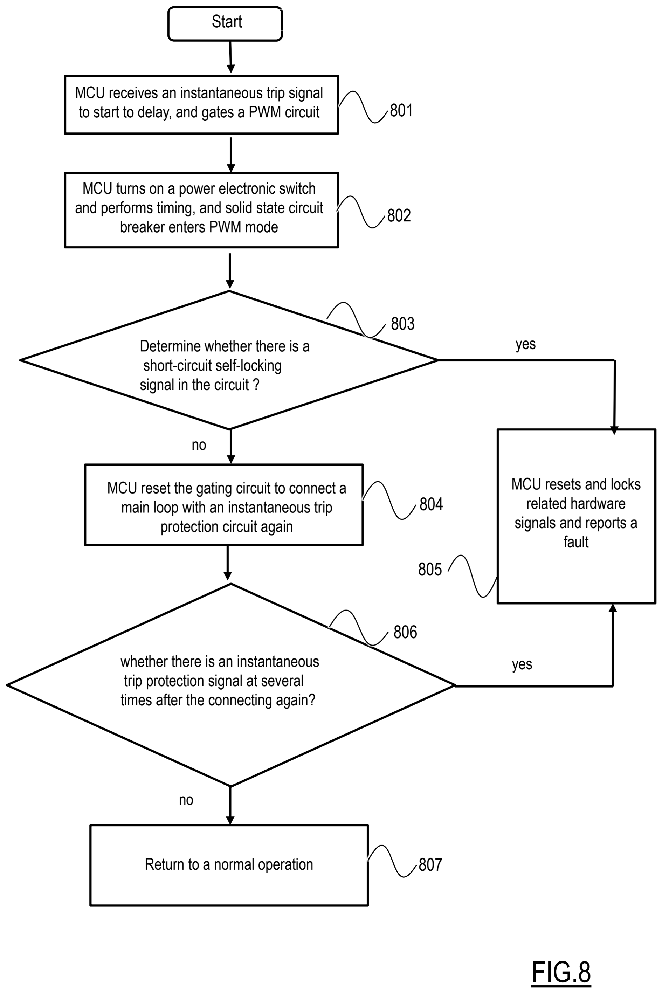

FIG. 8 illustrates a schematic flowchart of a method 800 for controlling reclosing of a solid-state circuit breaker according to another embodiment of the present disclosure.

The method 800 may be a more detailed implementation of the method 700. However, those skilled in the art can understand that the embodiments of the present disclosure are not limited thereto.

As shown in FIG. 8, at 801 of the method 800, an MCU receives an instantaneous trip signal transmitted by the instantaneous trip protection circuit 101, and starts to delay, and in the delay period or at an ending of the delay period, i.e., a time t2, transmits a switching signal to the gating circuit 103 to switch the main loop to connect to the PWM circuit 102 from the instantaneous trip protection circuit 101.

At 802, the MCU turns on the power electronic switch and performs timing, and the solid-state circuit breaker enters a PWM mode, that is, the charging period t2~t3.

At 803, the MCU ends the timing, and at this time, i.e., at the time t3, whether there is a short-circuit self-locking signal in the circuit is determined. If not, at 804, the MCU may reset the gating circuit 103 to disconnect the main loop from the PWM circuit 102 and connect it with the instantaneous trip protection circuit 101 again through the gating circuit 103.

At 806, whether the instantaneous trip protection circuit 101 transmits an instantaneous trip protection signal again after the instantaneous trip protection circuit 101 is connected with the main loop again is determined.

If not, at 807, the solid-state circuit breaker may return to a normal operation. This may correspond to successful reclosing of the solid-state circuit breaker under a surge condition.

If the instantaneous trip protection circuit 101 transmits the instantaneous trip protection signal again, this may correspond to a high-impedance long-line short-circuit condition, and the process proceeds to 805. At 805, the MCU resets and locks related hardware signals and reports a fault.

At 803, if there is the short-circuit self-locking signal, this corresponds to a short-circuit condition, and the process proceeds to 805. At 805, the MCU resets and locks related hardware signals and reports a fault.

Although steps 701 to 705 and 801 to 807 are illustrated to be performed in orders in FIGs. 7 and 8, those skilled in the art can understand that the methods 700 and 800 can be performed in an order other than those shown in FIGs. 7 and 8 without departing from the teachings of the embodiments of the present disclosure.

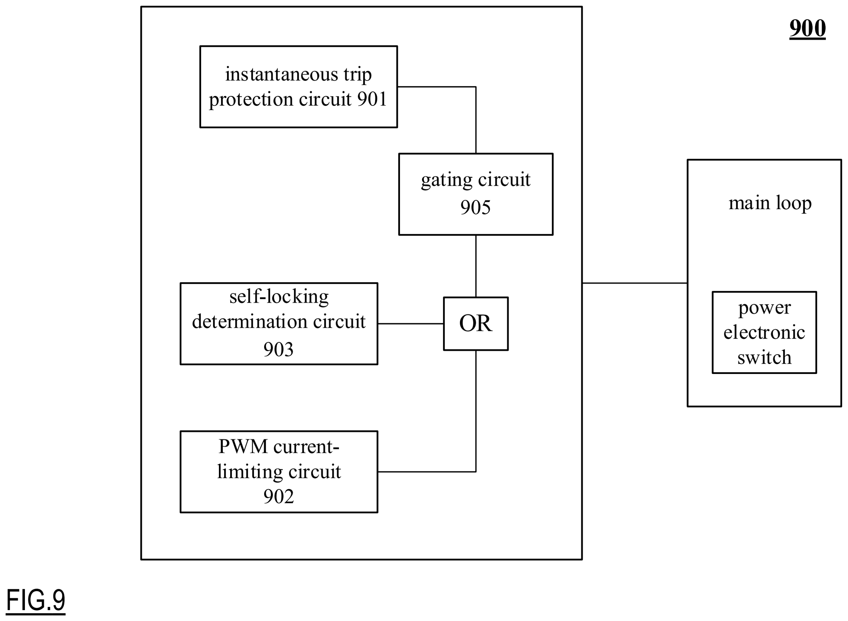

FIG. 9 illustrates a schematic block diagram of a solid-state circuit breaker 900 according to another embodiment of the present disclosure.

As shown in FIG. 9, the solid-state circuit breaker 900 may include a power electronic switch, an instantaneous trip protection circuit 901, a pulse width modulation (PWM) current-limiting circuit 902, a self-locking determination circuit 903, a gating circuit 905 and an OR gate.

The power electronic switch may be located in a main loop. The instantaneous trip protection circuit 901 may be configured to output a first signal for controlling the power electronic switch based on a current in the main loop. The PWM current-limiting circuit 902 may be configured to limit the current of the main loop and generate a PWM pulse. The self-locking determination circuit 903 is configured to compare a charging voltage of a fast-charging and slow-discharging capacitor with a self-locking threshold and output a self-locking determination signal. The OR gate is configured to be connected to the PWM current-limiting circuit 902 and the self-locking determination circuit 903. The gating circuit 905 is connected to the instantaneous trip protection circuit 901, the OR gate and the power electronic switch, and is configured to selectively connect the instantaneous trip protection circuit 901 or the PWM current-limiting circuit 902 and the self-locking determination circuit 903 with the main loop.

The instantaneous trip protection circuit 901 in FIG. 9 may correspond to the instantaneous trip protection circuit 101 in FIG. 1, and the gating circuit 905 in FIG. 9 may correspond to the gating circuit 103 in FIG. 1. Their operations have been described in detail with reference to FIGs. 1 to 6, and will not be repeated here.

The PWM current-limiting circuit 902, the self-locking determination circuit 903 and the OR gate in FIG. 9 may correspond to the PWM circuit 102 in FIG. 1.

In an example, the apparatus 900 may further include a microcontroller unit MCU (not shown) connected to the instantaneous trip protection circuit 901, the PWM current-limiting circuit 902 and the gating circuit 905, and may be configured to: output a switching signal to the gating circuit 905 to connect the instantaneous trip protection circuit 901 or the PWM current-limiting circuit 902, the self-locking determination circuit 903 and the OR gate with the main loop; enable the power electronic switch to be turned on; output a reset signal to the instantaneous trip protection circuit 901; and output the reset signal to the self-locking determination circuit 903.

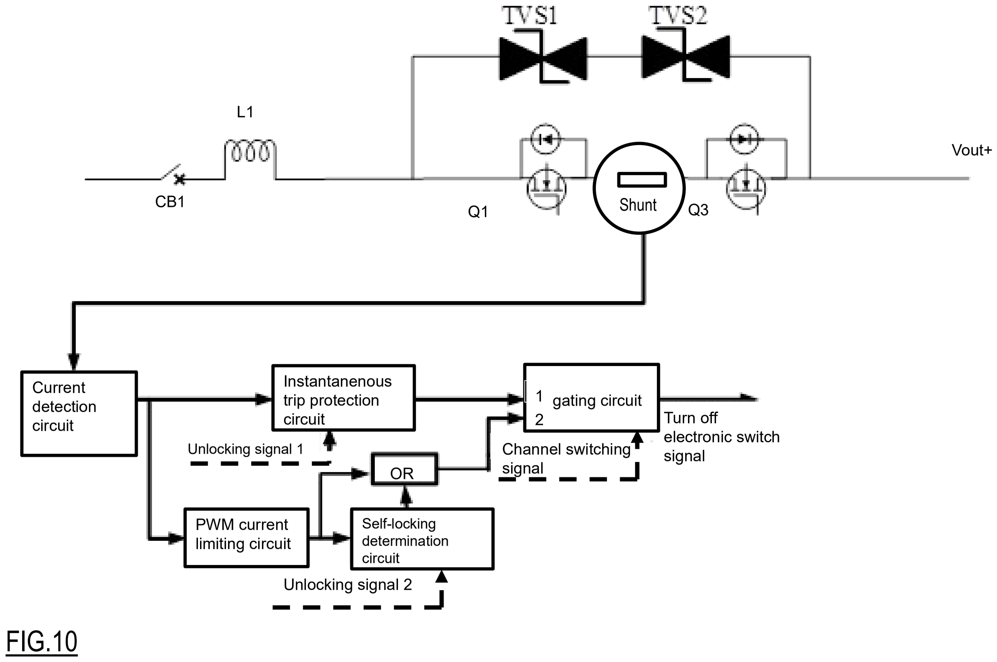

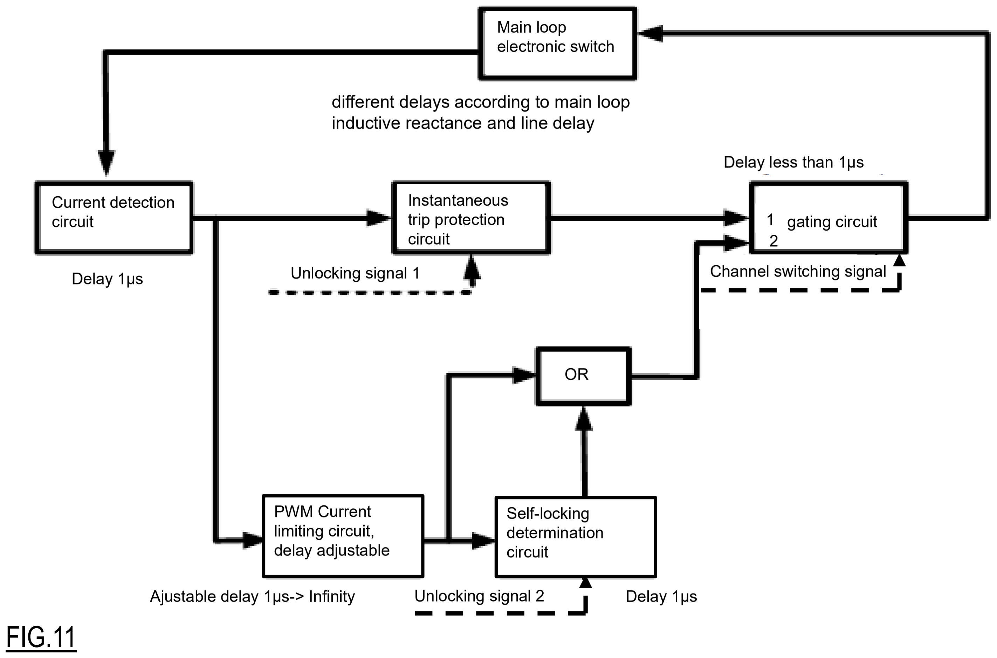

FIG. 10 illustrates a schematic circuit topology diagram of a solid-state circuit breaker according to another embodiment of the present disclosure, and FIG. 11 illustrates a simplified circuit topology diagram of a solid-state circuit breaker according to another embodiment of the present disclosure.

In the structures shown in FIGs. 10 and 11, CB1 is an isolating switch. Q1 and Q3 are main loop solid-state switches, i.e., SiC MOSFET, and TVS1 and TVS2 are solid-state switch voltage protection devices. Shunt, as a representation, is a current detection sensor, which transmits a current signal to a current detection circuit, for example, it may be the aforementioned sampling resistor R.

When the solid-state circuit breaker works normally, a main loop electronic device is turned on, and the current signal detected by the current detection circuit is not enough to trigger an overcurrent signal.

When an overcurrent occurs in the circuit, at a time t0, the current detection circuit first detects generation of a large current, and at the same time, transmits the overcurrent signal to an instantaneous trip protection circuit and a PWM current-limiting circuit. At this time, a gating circuit is in channel 1 by default, i.e., a state in which the instantaneous trip protection circuit is connected with a main loop, receives a signal of the instantaneous trip protection circuit, and outputs a signal to turn off an electronic switch after receiving the signal, thereby turning off the electronic switch immediately. The whole process may be completed in 3µs.

At the same time, an MCU receives the overcurrent signal, and will quickly turn off a lower tube Q3 in 50µs.

At a time t1, for example, at 270µs, the MCU will transmit a channel switching signal, so that the gating circuit switches to channel 2, that is, a state in which the PWM current-limiting circuit, a self-locking determination circuit and an OR gate are connected with the main loop.

At a time t2, i.e. 500µs, the MCU may transmit unlocking signal 1 and unlocking signal 3, and at the same time, switch on driving of an upper tube Q1 and the lower tube Q3 to turn on a power electronic switch.

At a time t3, i.e., 2ms, if an output of the gating circuit is still high, it means that reclosing fails, and a fault of the main loop is short-circuit. The MCU gives a mechanical switch trip signal. If the output of the gating circuit is low, it means that the reclosing is successful, and the fault of the main loop is short-term overcurrent (less than 2ms) or surge. Then, the MCU gives unlocking signal 1, and switches a path of the gating circuit to channel 1, that is, connects the instantaneous trip protection circuit with the main loop.

After that, if the instantaneous trip protection circuit will not trigger the power electronic switch to be turned off again, the solid-state circuit breaker is successfully reclosed and resumes a normal operation.

If the instantaneous trip protection circuit triggers the power electronic switch to be turned off again, the MCU may reset the state and report the fault.

Although the present disclosure has been described with exemplary embodiments, various changes and modifications can be suggested to those skilled in the art. It is intended that the present disclosure encompasses such changes and modifications falling in the scope of the appended claims.

Any description in the present disclosure should not be understood as implying that any particular element, step or function is an essential element that must be included in the scope of the claims. The scope of the patent subject matter is limited only by the claims.

## Claims

1. A solid-state circuit breaker, comprising:
a power electronic switch located in a main loop;
an instantaneous trip protection circuit configured to output a first signal for controlling the power electronic switch based on a current in the main loop;
a pulse width modulation (PWM) circuit configured to charge a load in a PWM current-limiting mode based on the current of the main loop and output a second signal for controlling the power electronic switch; and
a gating circuit connected to the instantaneous trip protection circuit, the PWM circuit and the power electronic switch, and configured to selectively connect the instantaneous trip protection circuit or the PWM circuit with the main loop.

2. The solid-state circuit breaker of claim 1, wherein the gating circuit is configured to connect the PWM circuit with the main loop after the instantaneous trip protection circuit outputs the first signal to turn off the power electronic switch at an initial turn-off time.

3. The solid-state circuit breaker of claim 2, wherein the power electronic switch is turned on after a delay period has elapsed since it was turned off, and
the PWM circuit is configured to charge the load with a PWM pulse based on the current of the main loop in a charging period after the delay period.

4. The solid-state circuit breaker of claim 3, wherein when a charging voltage of a fast-charging and slow-discharging capacitor causes a short-circuit self-locking threshold to be reached during the charging period, the PWM circuit is configured to output the second signal for turning off the power electronic switch, and
wherein the gating circuit is further configured to disconnect the PWM circuit from the main loop and connect the reset instantaneous trip protection circuit with the main loop after an end of the charging period.

5. The solid-state circuit breaker of claim 3 or 4, wherein when a charging voltage of a fast-charging and slow-discharging capacitor causes a short-circuit self-locking threshold not to be reached during the charging period, the gating circuit is further configured to disconnect the PWM circuit from the main loop and connect the reset instantaneous trip protection circuit with the main loop after an ending of the charging period.

6. The solid-state circuit breaker of claim 5, wherein a circuit fault is identified when the instantaneous trip protection circuit outputs the first signal for turning off the power electronic switch again after the end of the charging period.

7. The solid-state circuit breaker of claim 5 or 6, wherein the solid-state circuit breaker operates normally when the instantaneous trip protection circuit does not output the first signal after the end of the charging period.

8. The solid-state circuit breaker of any one of the claims 4 to 7, wherein the PWM circuit is configured to output the second signal for turning off the power electronic switch before the ending of the charging period, to turn off the solid-state circuit breaker and make it lockout.

9. The solid-state circuit breaker of any one of the claims 3 to 8, wherein the PWM circuit comprises:
a PWM current-limiting circuit configured to limit the current of the main loop and generate the PWM pulse;
a self-locking determination circuit configured to determine whether a self-locking threshold is reached based on a charging voltage of a fast-charging and slow-discharging capacitor, and output a self-locking determination signal; and
an OR gate configured to be connected to the PWM current-limiting circuit and the self-locking determination circuit, and output the second signal.

10. The solid-state circuit breaker of claim 9, further comprising:
a microcontroller unit (MCU) connected to the instantaneous trip protection circuit, the PWM current-limiting circuit, the self-locking determination circuit and the gating circuit, and configured to:
output a switching signal to the gating circuit to connect the instantaneous trip protection circuit or the PWM circuit with the main loop;
enable the power electronic switch to be turned on;
output a reset signal to the instantaneous trip protection circuit; and
output a reset signal to the self-locking determination circuit.

11. A method for controlling reclosing of a solid-state circuit breaker, the method comprising:
turning off a power electronic switch in the solid-state circuit breaker through an instantaneous trip protection circuit at an initial turn-off time;
connecting a pulse width modulation (PWM) circuit with a main loop;
turning on the power electronic switch after a delay period has elapsed;
charging a load through the PWM circuit in a PWM current-limiting mode during a charging period; and
disconnecting the pulse width modulation (PWM) circuit from the main loop and connecting the reset instantaneous trip protection circuit with the main loop after an end of the charging period.

12. The method of claim 11, further comprising:
turning off the solid-state circuit breaker and making it lockout based on a self-locking determination signal output from the PWM circuit during the charging period.

13. The method of claim 11, wherein the solid-state circuit breaker operates normally after the reset instantaneous trip protection circuit is connected with the main loop, and
wherein the method further comprises:
turning off the power electronic switch again through the instantaneous trip protection circuit after the reset instantaneous trip protection circuit is connected with the main loop.
